# EUROPÄISCHE PATENTANMELDUNG

(11) **EP 1 801 964 A1**
(43) Veröffentlichungstag der Anmeldung: **27.06.2007**
(21) Anmeldenummer: 05112514.4
(22) Anmeldetag: 20.12.2005
(51) Int. Cl.: H03F 3/38, H03F 1/26, H03F 3/45, G01G 3/147

(54) **Verfahren zur Korrektur eines analogen Verstärker-Ausgangssignals, Verstärkermodul und Messvorrichtung**

(71) Anmelder: Mettler-Toledo AG, 8606 Greifensee (CH)
(72) Erfinder: Bucher, Cyrill, 8610, Uster (CH); Reber, Daniel, 8322, Madetswil (CH); Ouellette, Philip R., 43081, Westerville (US)

(57) **Zusammenfassung**

Das erfindungsgemässe Verfahren dient der Korrektur von Übertragungsfehlern eines analogen Verstärkers (OP,DOP), verursacht durch dessen physikalisch begrenzte Wirkungsweise beim Nachfolgen eines Schaltsprunges im Verstärker-Eingangssignal (S₁,S₂). In einer Messvorrichtung, die mindestens einen Sensor sowie eine mit diesen Komponenten verbundene Signalverarbeitungseinheit beinhaltet, wobei die Signalverarbeitungseinheit mindestens einen Modulator (MO) und/oder einen Multiplexer (MX), einen analogen Verstärker (OP,DOP) und mindestens eine dem analogen Verstärker nachgeschaltete Verarbeitungsstufe (AD,AE) aufweist, wird abhängig vom Schaltzeitpunkt des Schaltsprunges die nachgeschaltete Verarbeitungsstufe (AD,AE) vermittels eines zwischen dem analogen Verstärker (OP,DOP) und der Verarbeitungsstufe (AD,AE) angeordneten Schalters, welcher durch eine Ausblendsteuerung (AS) angesteuert wird, während einer vorbestimmten Ausblendphasendauer (t₁ bis t₂, t₃ bis ...) vom analogen Verstärker (OP,DOP) getrennt, und/oder abhängig vom Schaltzeitpunkt des Schaltsprunges die nachgeschaltete Verarbeitungsstufe (AD,AE) während einer vorbestimmten Ausblendphasendauer (t₁ bis t ₂, t₃ bis ...) durch eine Ausblendsteuerung (AS) blockiert.

## Beschreibung

Die Erfindung betrifft ein Verfahren, ein Verstärkermodul und eine Messvorrichtung, deren Signal in einer Signalverarbeitungseinheit verstärkt, aufbereitet und an eine Ausgabe übermittelt wird.

Analoge Verstärker, insbesondere Operationsverstärker und Differenzverstärker werden in Signalverarbeitungseinheiten verwendet, in denen ein Ausgangssignal beispielsweise eines Temperatur-, Feuchte-, Kraft-, oder Drucksensors aufbereitet und verarbeitet wird. Meistens werden Sensoren und Signalverarbeitungseinheiten zu so genannten Messvorrichtungen zusammengestellt und im industriellen Umfeld eingesetzt. Eine bedeutende Gruppe von Messvorrichtungen mit sehr hohen Anforderungen an eine Signalverarbeitungseinheit stellen die Kraftmessvorrichtungen dar, insbesondere die gravimetrischen Messvorrichtungen.

Die gravimetrischen Messgeräte wie Thermoanalysegeräte, Waagen, Feuchtemessgeräte und dergleichen weisen je nach Anforderungen an ihre Genauigkeit beziehungsweise ihre Auflösung, unterschiedliche Konstruktionstypen von Kraftmesszellen auf. Ein recht kostengünstiger Konstruktionstyp stellt die Kraftmesszelle mit einem Verformungskörper und Dehnungsmessstreifen dar.

DMS- Kraftmesszellen bzw. Messvorrichtungen arbeiten in der Regel nach dem Prinzip von Widerstandsmessungen. Sie nutzen den Effekt aus, dass der Widerstand eines DMS proportional zu dessen Dehnung, d. h. dessen relativen Längenänderung, und diese wiederum proportional zu der auf die Kraftmesszelle wirkenden Kraft ist. Zur genauen Messung werden die Dehnungsmessstreifen dabei häufig in einer Brücke verschaltet.

Die Brückenschaltung beziehungsweise auch die Halbbrückenschaltung ist eine im Stand der Technik bekannte Beschaltung, wobei mindestens einer der in der Brückenschaltung verwendeten Widerstände in seinem Widerstandsverhalten variabel ist. Diese Voraussetzungen erfüllen viele bekannte Sensoren, beispielsweise ändern Dehnungsmessstreifen ihren elektrischen Widerstand in Abhängigkeit ihrer Dehnung.

Aus Kostengründen und der Einfachheit halber greift man im allgemeinen auf eine Gleichspannungsversorgung der Messvorrichtung und damit auch auf eine Gleichspannungsverstärkung zurück, obwohl diese aufgrund ihrer üblichen technischen Beschränkungen häufig Nachteile haben, nämlich Gleichspannungsfehler, wie Thermospannungsfehler oder Offsetspannungen im analogen Verstärker, sowie übermässiges Niederfrequenzrauschen im gesamten Schaltkreis. Thermospannungen können an den Anschlusspunkten der notwendigen Verkabelung zwischen der Widerstandsbrücke und nachgeschalteten analogen Verstärkern auftreten, nämlich dann, wenn dort unterschiedliche Materialien und Temperaturen vorliegen. Diese Fehler müssen auf einem noch akzeptablen Niveau gehalten bzw. das Messsignal von diesen Fehlspannungen klar abgehoben werden.

Die oben genannten Messfehler, wie thermoelektrische Effekte, Rauschen und Temperatureffekte in nachgeschalteten analogen Verstärkern werden häufig durch zusätzliche Wechselspannungsmodulations und -verstärkungstechniken vermindert. Diese Modulationsverstärkungstechnik wird auch in der EP 0 760 936 B2 offenbart. Ein Trägerfrequenzgenerator erzeugt ein Wechselspannungssignal (Rechteckwechselspannungssignal), das an eine Brückenschaltung gelegt wird. Das Brücken-Ausgangssignal wird über einen symmetrischen Differenzverstärker an einen Demodulator weitergeleitet. Der Demodulator in Form eines Umschalters wird dabei vom Trägerfrequenzgenerator gesteuert.

Analoge Verstärkerschaltungen mit geschalteten Verstärkern werden in vielen Anwendungen eingesetzt. Dabei werden die beiden von der Messbrücke kommenden Signale vermittels zweier Analogumschalter während der einen Messphase je einem Operationsverstärker zugeführt. Während einer zweiten Messphase werden die Signale jedoch überkreuzt dem jeweils anderen Operationsverstärker eingespeist. Dieses abwechslungsweise Vertauschen der Sensorsignale wird mit beispielsweise zwei weiteren Analogumschaltern wieder rückgängig gemacht, indem die beiden verstärkten Sensorsignale ebenfalls gleichphasig zu den Eingangsumschaltern jeweils direkt, beziehungsweise überkreuzt geschaltet werden.

Dieses Vorgehen bietet sehr viele Vorteile.

Erstens kann die Offsetspannungsdrift der Operationsverstärker unterdrückt werden. Bei einem nicht geschalteten Differenzverstärker erscheint nach der Subtraktion der beiden Ausgangssignale des Differenzverstärkers zusätzlich zum verstärkten Sensorsignal noch die mit dem Differenzverstärkungsfaktor verstärkte Offsetspannungsdifferenz beider Operationsverstärker. Bei einem geschalteten Differenzverstärker wird die Offsetspannung des ersten Operationsverstärkers einmal zum ersten Sensorsignal addiert während die Offsetspannung des zweiten Operationsverstärkers dem zweiten Sensorsignal addiert wird. Werden nun in der zweiten Messphase die Sensorsignale überkreuzt an die Operationsverstärker angelegt, erhalten dieselben Sensorsignale die Offsetspannung des jeweils anderen Operationsverstärkers. Auf diese Weise ändert die Offsetspannungsdifferenz des geschalteten Differenzverstärkers in jeder Messphase das Vorzeichen. Wenn sich die Messphasen beispielsweise genügend schnell folgen, so sind die Vorzeichenwechsel schnell genug, dass sie durch eine Tiefpassfilterung aus dem Signal entfernt werden können.

Zweitens kann das 1/f-Rauschen unterdrückt werden. Jeder Operationsverstärker zeigt unterhalb einer gewissen Frequenzschwelle einen signifikanten Anstieg des Rauschens, welcher in etwa einem 1/f-Gesetz folgt. In vielen Applikationen, beispielsweise in Kraftmessvorrichtungen mit DMS- Kraftmesszellen interessieren nur statische oder sehr langsam veränderliche Signale, zum Beispiel 0 bis 1 Hertz. Bei einem nicht geschalteten Differenzverstärker wird diesen Signalen das bei diesen Frequenzen dominante 1/f-Rauschen überlagert, welches die Qualität der verstärkten Sensorsignale erheblich beeinträchtigt. Bei einem geschalteten Differenzverstärker werden durch die Umschalter am Eingang des Differenzverstärkers oder des Sensors die statischen oder tieffrequenten Sensorsignale im Frequenzbereich mit dem Umschaltsignal einer Umschaltsteuerung gefaltet und unter anderem auf die Frequenz des Umschaltsignals angehoben. Liegt diese genügend oberhalb der 1/f-Frequenzschwelle, wird dem nun gefalteten Sensorsignal nur das an der Frequenzstelle viel kleinere weisse Rauschen des Operationsverstärkers überlagert. Weißes Rauschen ist in den Ingenieur- und Naturwissenschaften bekannt als ein physikalisches Rauschen mit konstanter Amplitude im Leistungsdichtespektrum. Die Leistung eines stochastischen Signals ist erhältlich, wenn sein Leistungsdichtespektrum über den Gesamtwiderstand integriert (von minus unendlich bis plus unendlich) wird. Das weiße Rauschen im theoretischen Sinne hat somit eine unendliche Signalenergie. Im praktischen Fall fällt beim weißen Rauschen jedoch die Leistungsdichte für sehr große Frequenzen ab.

Durch die zweiten Umschalter am Ausgang des Differenzverstärkers werden die Sensorsignale frequenzmässig wieder in den DC- bzw. tieffrequenten Bereich zurückgefaltet. Zudem wird das 1/f-Rauschen der Operationsverstärker durch die zweiten Umschalter auf die Umschaltfrequenz hochgefaltet. Dieses Rauschen kann anschliessend mit einem Tiefpassfilter unterdrückt werden.

Grundsätzlich gelten die oben aufgeführten Überlegungen für eine Modulation mit beliebiger Kurvenform. Zum Beispiel können die Sensorsignale am Eingang des Differenzverstärkers sinusförmig moduliert werden. Am Ausgang des Differenzverstärkers lassen sich die Signale mit sinusförmig angesteuerten Demodulatoren wieder zurückgewinnen.

Die Wahl eines Sinussignals erfolgt dann, wenn beispielsweise eine Wechselspannungsquelle zur Verfügung steht oder wenn die Robustheit des Signals über lange Verbindungsdistanzen im Vordergrund steht. Wegen ihres geringeren schaltungstechnischen Aufwands und dadurch der geringeren Kosten, hat sich in der Praxis die Modulation mit Rechtecksignalen durchgesetzt. Diese wird häufig mittels Analogschaltern realisiert.

Bei einer Rechteckwechselspannungsmodulation, beispielsweise mittels Analogschaltern wechseln die Verstärker-Eingangssignale augenblicklich. Da aber analoge Verstärker nur eine begrenzte Bandbreite und Anstiegszeit aufweisen, können sie mit ihren Ausgangssignalen den Eingangssignalen nicht sofort folgen. Ist die Anstiegszeit das begrenzende Element, wird das Verstärker-Ausgangssignal in etwa linear mit der Zeit ansteigen. Ist die Bandbreite der limitierende Faktor, wird das Verstärker-Ausgangssignal in etwa ein Einschwingen in Form einer e-Funktion aufweisen. Auf jeden Fall gilt während des Einschwingvorgangs die Annahme, dass das Verstärker-Ausgangssignal dem mit dem Verstärkungsfaktor multiplizierten Verstärker-Eingangssignal entspricht, nicht mehr. Die Annahme geht aber von einem konstanten Verstärkungsfaktor aus. Solange die Bandbreite und Anstiegszeit konstant bleiben, können die dadurch verursachten Übertragungsfehler auf das Verstärker-Ausgangssignal als konstant angesehen werden. Diese Übertragungsfehler lassen sich beispielsweise in eine Skalierung fest mit einbeziehen und fallen damit weg.

Neue, sehr homogene Materialien für Kraftmesszellen- Verformungskörper, modernste Fertigungsmethoden sowie präzise Dehnmessstreifen ermöglichen die Herstellung hoch auflösender Kraftmesszellen auch auf Basis der DMS- Technologie. Um die Performance dieser hoch auflösenden Kraftmesszellen zu nutzen, muss die Signalverarbeitungseinheit den neuen Anforderungen entsprechend angepasst sein.

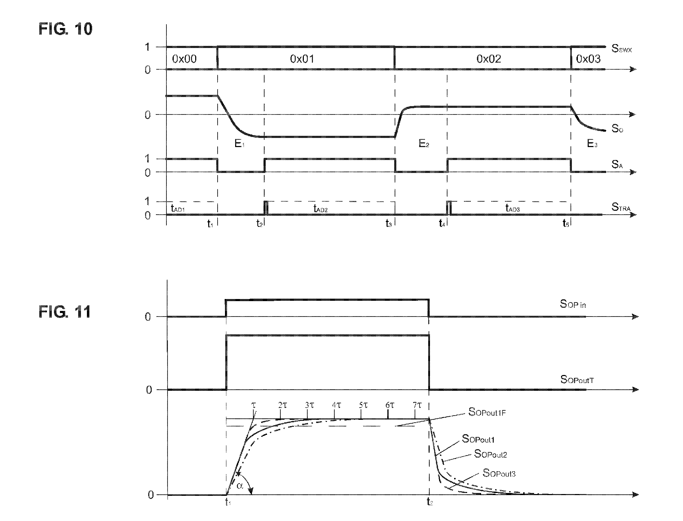

Umfangreiche Untersuchungen an verschiedenen baugleichen analogen Verstärkern zeigten, dass die Bandbreite und die Anstiegszeit der analogen Verstärker teilweise massive Exemplarstreuungen aufweisen und sich unter vergleichbaren Temperatureinflüssen zudem unterschiedlich verhalten (vergleiche Figur 11). Unter Exemplarstreuungen sind hier die Abweichungen im Verhalten baugleicher Elemente untereinander zu verstehen. Die Untersuchungen haben folglich ergeben, dass die Geschwindigkeit des Einschwingvorgangs und deshalb auch der resultierende Amplitudenfehler veränderlich sind. Somit ist auch die Skalierung veränderlich und unterliegt ebenfalls den Exemplarstreuungen und den Temperatureinflüssen. Diese Übertragungsfehler müssten durch einen individuellen Abgleich der Exemplarstreuungen und durch eine Kompensation der Temperatureinflüsse beseitigt werden. Solche Vorgänge erzeugen einen erheblichen Mehraufwand und verteuern die Produktion und das Produkt.

Der vorliegenden Erfindung liegt daher die Aufgabe zugrunde, ein Verfahren zur Korrektur von Übertragungsfehlern verursacht durch die physikalisch begrenzte Wirkungsweise mindestens eines analogen Verstärkers zu schaffen, der Teil der Signalverarbeitungseinheit einer Messvorrichtung ist. Ferner soll auch eine gemäss diesem Verfahren arbeitendes Verstärkermodul und eine Messvorrichtung geschaffen werden.

Diese Aufgabe wird mit einem Verfahren, einem Verstärkermodul und einer Messvorrichtung gelöst, welche die in Anspruch 1, Anspruch 11 und Anspruch 12 angegebenen Merkmale aufweisen. Vorteilhafte Ausgestaltungen der Erfindung sind in weiteren Ansprüchen angegeben.

Das erfindungsgemässe Verfahren dient zur Korrektur von Übertragungsfehlern eines analogen Verstärkers, verursacht durch dessen physikalisch begrenzte Wirkungsweise beim Nachfolgen eines Schaltsprunges im Verstärker-Eingangssignal. Eine Signalverarbeitungseinheit weist mindestens einen Modulator und/oder einen Multiplexer, einen analogen Verstärker und mindestens eine dem analogen Verstärker nachgeschaltete Verarbeitungsstufe auf, wobei
a. abhängig vom Schaltzeitpunkt des Schaltsprunges die nachgeschaltete Verarbeitungsstufe während einer vorbestimmten Ausblendphasendauer vom analogen Verstärker getrennt wird und/oder
b. abhängig vom Schaltzeitpunkt des Schaltsprunges die nachgeschaltete Verarbeitungsstufe während einer vorbestimmten Ausblendphasendauer blockiert wird.

Dabei verfügt die Ausblendsteuerung über Mittel, die einen Schaltsprung detektieren können um damit die Ausblendphase zu triggern. Ist die Messvorrichtung mit einem Modulator und/oder einem Multiplexer mit einer Umschaltsteuerung versehen, können die Ausblendsignale der Ausblendsteuerung in Abhängigkeit der Umschaltsignale der Umschaltsteuerung getriggert werden.

Da die analogen Verstärker teilweise massive Exemplarstreuungen aufweisen und sich unter vergleichbaren Temperatureinflüssen zudem unterschiedlich verhalten, wird die Ausblendphasendauer vorzugsweise in Abhängigkeit der Anstiegszeit des analogen Verstärkers vorbestimmt. Wenn die Ausblendphasendauer der Anstiegszeit des analogen Verstärkers, multipliziert mit einem Faktor welcher zwischen 2 und 7 liegt, entspricht, wird sichergestellt, dass die Exemplarstreuungen und die Temperatureinflüsse im Verstärker-Ausgangssignal spätestens am Signalausgang der nachgeschalteten Verarbeitungsstufe weitgehend eliminiert sind. Die Anstiegszeit eines analogen Verstärkers lässt sich aus der Anstiegsrate (englisch Slew-rate in ^{v}/_{µs}) berechnen, die üblicherweise dem Datenblatt des Verstärkerherstellers zu entnehmen ist.

Falls die Bandbreite das limitierende Element des Verstärkers ist, wird das Ausgangssignal in etwa einer Exponentialfunktion folgen, welche eine charakteristische Zeitkonstante aufweist. Idealerweise entspricht die Ausblendphasendauer der Zeitkonstanten des analogen Verstärkers, multipliziert mit einem Faktor, welcher zwischen 4 und 10 liegt. Die Zeitkonstanten können beispielsweise durch Berechnung oder durch Messungen ermittelt werden.

Sinnvollerweise entspricht daher die Ausblendphasendauer entweder der Anstiegszeit oder der Zeitkonstanten des Verstärkers, multipliziert mit einem Faktor, welcher zwischen 2 und 10 liegt. Massgebend ist dabei jeweils der grössere Wert.

In einer vorzugsweisen Ausgestaltung der Erfindung wird die nachgeschaltete Verarbeitungsstufe vom analogen Verstärker mittels mindestens eines Schalters getrennt, wobei der Schalter zwischen dem analogen Verstärker und der nachgeschalteten Verarbeitungsstufe angeordnet ist und durch eine Ausblendsteuerung angesteuert wird.

In einer weiteren Ausgestaltung der Erfindung weist die Signalverarbeitungseinheit einen dem analogen Verstärker nachgeschalteten Demodulationsschalter auf, wobei eine Umschaltsteuerung des Modulators zur synchronen Demodulation des modulierten Signals auf den Demodulationsschalter einwirkt und eine Ausblendsteuerung während der Ausblendphasendauer mittels eines Ausblendsignals den Demodulationsschalter in einer hochohmigen Schaltstufe oder in einem hochohmigen Zustand hält.

Selbstverständlich kann die nachgeschaltete Verarbeitungsstufe eine Analog-Digital-Wandlerschaltung sein, wobei zur Erzeugung einer Ausblendphase eine Ausblendsteuerung auf einen Triggersignal-Schalter einwirkt und der Triggersignal-Schalter ein zur A/D-Wandlung notwendiges Triggersignal während der Ausblendphasendauer unterbricht.

Sofern die nachgeschaltete Verarbeitungsstufe eine Analog-Digital-Wandlerschaltung ist, kann zur Erzeugung einer Ausblendphase die Ausblendsteuerung mit einem Triggersignalgenerator welcher die zur A/D-Wandlung notwendigen Triggersignale erzeugt kombiniert werden. In dieser kombinierten Triggersignalgenerator/Ausblendsteuerung werden die von der Ausblendsteuerung erzeugten Ausblendsignale den Triggersignalen während der Ausblendphasendauer überlagert, oder die Generierung der Triggersignale wird unterdrückt oder verzögert ausgelöst.

Vorteilhafterweise ist der Modulator und/oder der Multiplexer mit einer Umschaltsteuerung versehen, so dass die Ausblendsignale der Ausblendsteuerung in Abhängigkeit der Umschaltsignale der Umschaltsteuerung generiert werden können.

Üblicherweise wird das Ausgangssignal mindestens eines Sensors dem Verstärker als Verstärker-Eingangssignal zugeführt. Selbstverständlich können auch die Ausgangssignale mindestens zweier Sensoren sequentiell vermittels des Multiplexers dem mindestens einen analogen Verstärker zugeführt werden.

In vorzugsweisen Ausführungen der Erfindung wird vermittels des Modulators das Verstärker-Eingangssignal oder die Eingangsspannung des Sensors vorzugsweise als Rechteckwechselspannungssignal moduliert.

Die oben erwähnte Signalverarbeitungseinheit kann auch als Verstärkermodul ausgestaltet sein und in einer Vielzahl von Messvorrichtungen verwendet werden. Dieses Verstärkermodul oder integrierte Verstärkermodul weist mindestens einen Modulator und/oder einen Multiplexer mit mindestens einer Umschaltsteuerung, dem Modulator und/oder dem Multiplexer nachgeschaltet mindestens einen analogen Verstärker, und diesem Verstärker nachgeschaltet mindestens eine Verarbeitungsstufe auf, wobei die nachgeschaltete Verarbeitungsstufe mindestens ein Ausblendmittel beinhaltet, das der Erzeugung einer Ausblendphase mit einer vorbestimmten Ausblendphasendauer im Verstärker-Ausgangssignal dient.

Ebenso kann die Signalverarbeitungseinheit in einer Messvorrichtung angeordnet sein, welche zur mindestens einen Signalverarbeitungseinheit noch mindestens einen Sensor aufweist. Die Signalverarbeitungseinheit beinhaltet einen Modulator und/oder einen Multiplexer mit einer Umschaltsteuerung. Dem Modulator und/oder dem Multiplexer ist mindestens ein analoger Verstärker und diesem Verstärker mindestens eine Verarbeitungsstufe nachgeschaltet. Zudem weist die Signalverarbeitungseinheit mindestens ein Ausblendmittel auf, das der Erzeugung einer Ausblendphase mit einer vorbestimmten Ausblendphasendauer im Verstärker-Ausgangssignal dient.

In einer Ausführung der Messvorrichtung ist der Modulator unmittelbar vor dem analogen Verstärker angeordnet und dient der Modulation des Verstärker-Eingangssignals, um die vorangehend erläuterten Probleme bezüglich der Offsetspannungsdrift und dem 1/f-Rauschen zu umgehen.

In einer bevorzugten Ausführung der Messvorrichtung ist der Modulator vor dem mindestens einen Sensor angeordnet, wobei der Modulator der Modulation der Versorgungsspannung des Sensors, und dadurch der Modulation des Verstärker-Eingangssignals dient.

In einer besonders bevorzugten Ausführung der Messvorrichtung ist das Ausblendmittel ein der Signalverarbeitungseinheit zugeordneter Schalter und eine mit dem Schalter verbundene Ausblendsteuerung. Die Umschaltsignale der Umschaltsteuerung sind idealerweise zur Ansteuerung der Ausblendsteuerung geeignet, so dass keine zusätzlichen Elemente zur Detektierung der Schaltsprünge im Eingangssignal notwendig sind.

Die Ausblendsteuerung kann auf verschiedene Weise Steuersignale erzeugen. Zur Erzeugung der Ausblendsignale dient beispielsweise ein zusätzlicher Signalgenerator und ein EXOR- Element, das die Signalgeneratorsignale mit den Umschaltsignalen kombiniert. Die Signalgeneratorsignale und die Umschaltsignale werden den Signaleingängen des EXOR-Elements zugeführt. Das EXOR-Element weist eine so genannte Exklusiv-Oder-Funktion auf, welche in U. Tietze, Ch. Schenk, Halbleiterschaltungstechnik, 12. Auflage, 1. Nachdruck, Springer Verlag, Berlin 2002, Kapitel 7 beschrieben ist. Sobald die Eingangswerte ungleich sind, nimmt der Ausgang des EXOR-Elements den Wert 1 an. Somit wird die Ausblendphase und Phasendauer über den Phasenversatz des Signalgeneratorsignals gegenüber dem Umschaltsignal gesteuert.

Anstelle der vorangehend beschriebenen Ausführungsformen kann selbstverständlich das Eingangssignal des Verstärkers auf Signalsprünge mittels eines geeigneten Detektors überwacht werden. Sobald der Detektor einen Schaltsprung detektiert, wird ein entsprechendes Signal der Ausblendsteuerung zugeführt, welches die Ausblendphase triggert.

In einer weiteren Ausführung der Messvorrichtung weist diese einen dem analogen Verstärker nachgeschalteten Demodulationsschalter auf. Der Demodulationsschalter, welcher mit der Umschaltsteuerung des Modulators verbunden ist, weist eine im Demodulationsschalter integrierte hochohmige Schaltstufe auf oder kann in einem hochohmigen Zustand gehalten werden. Der Demodulationsschalter ist mit einer Ausblendsteuerung verbunden, wobei die Umschaltsignale der Umschaltsteuerung zur Ansteuerung der Ausblendsteuerung der hochohmigen Schaltstufe geeignet sind und die von der Ausblendsteuerung erzeugten Ausblendsignale mit den Umschaltsignalen kombinierbar oder diesen überlagerbar sind.

Sofern in der Messvorrichtung die nachgeschaltete Verarbeitungsstufe eine Analog-Digital-Wandlerschaltung ist, kann das Ausblendmittel ein Triggersignal-Schalter und eine mit dem Triggersignal-Schalter verbundene Ausblendsteuerung sein, wobei der Triggersignal-Schalter ein zur A/D-Wandlung notwendiges Triggersignal unterbricht. Idealerweise werden auch hier die Umschaltsignale der Umschaltsteuerung zur Ansteuerung beziehungsweise Triggerung der Ausblendsteuerung herangezogen.

Ein weiteres Ausblendmittel in einer Messvorrichtung mit einer Analog-Digital-Wandlerschaltung als nachfolgende Verarbeitungsstufe kann eine kombinierte Triggersignalgenerator/Ausblendsteuerung sein, welche der Erzeugung eines oder mehrerer zur A/D-Wandlung notwendigen Triggersignale dient, wobei die Umschaltsignale der Umschaltsteuerung zur Ansteuerung der Ausblendsteuerung geeignet sind und die Ausblendsteuerung der Freigabe beziehungsweise der Blockierung der Triggersignale dient.

Der mindestens eine Sensor der Messvorrichtung kann ein Feuchtesensor, ein Temperatursensor, ein Drucksensor eine Kraftmesszelle mit Dehnungsmessstreifen oder eine Kraftmesszelle nach dem Prinzip der elektromagnetischen Kraftkompensation sein.

Je nach dem Aufbau der Signalverarbeitungseinheit kann das mittels Ausblenden bereinigte Verstärker- Ausgangssignal durch verschiedene Massnahmen auf den zu erwartenden Verstärker- Ausgangssignalwert eines idealen analogen oder digitalen Verstärkers gebracht werden. In einer analog arbeitenden Signalverarbeitungseinheit gelingt dies am einfachsten mittels eines R/C Tiefpassgliedes. Dies entspricht einer klassischen Sample and Hold-Technik. Selbstverständlich kann auch mittels eines Korrekturfaktors die nach der A/D- Wandlung digitalisierten Messsignale mittels einem dem A/D-Wandler nachgeschalteten Prozessor korrigiert werden, sofern die fehlenden Signalanteile der Ausblendphasen nicht überbrückt, sondern auf eine fixe Spannung, beispielsweise 0.0 V gesetzt werden.

In hochpräzisen Messvorrichtungen mussten bisher sehr präzise arbeitende Verstärker verwendet werden, um die geforderte Genauigkeit zu erreichen. Diese präzisen und schnellen Verstärker sind sehr teuer und brauchen viel Strom. Durch das erfindungsgemässe Verfahren können daher in der erfindungsgemässen Messvorrichtung sehr kostengünstige und weniger präzise Verstärker problemlos verwendet werden, ohne die Genauigkeit der Messvorrichtung zu beeinträchtigen. Dies ist in besonderem Masse dann der Fall, wenn eine Signalverarbeitungseinheit mehrere hintereinander geschaltete Verstärker aufweist und vermittels eines einzigen Ausblendmittels am Schluss der Verstärkerkette die Fehler aller Verstärker eliminiert werden.

Selbstverständlich kann auch jeder einzelne Verstärker ein ihm zugeordnetes Ausblendmittel aufweisen. Idealerweise wird eine solche Ausführung als integriertes Verstärkermodul konzipiert, welches geeignet zur Durchführung des vorangehend beschriebenen Verfahrens ist.

Nachfolgend wird die Erfindung anhand von Zeichnungen näher erläutert. Dabei zeigt:
- Figur 1: eine schematisch dargestellte Messvorrichtung mit einem als Wheatstonebrücke dargestellten Sensor und mit einer Signalverarbeitungseinheit die mit einem Ausblendmittel versehen ist, welches einen Schalter und eine mit dem Schalter verbundene Ausblendsteuerung beinhaltet;
- Figur 2: die Messvorrichtung aus Figur 1 mit einer Ausblendsteuerung, die einen Signalgenerator und ein EXOR-Element aufweist.
- Figur 3: eine schematisch dargestellte Messvorrichtung mit einem als Wheatstonebrücke dargestellten Sensor und mit einer Signalverarbeitungseinheit, die mit einem Ausblendmittel versehen ist, welches eine in einem Demodulator integrierte hochohmige Schaltstufe und eine mit dem Demodulator verbundene Ausblendsteuerung beinhaltet;
- Figur 4: die wichtigsten, in Figur 1, Figur 2 und Figur 3 auftretenden Signalverläufe;
- Figur 5: eine schematisch dargestellte Messvorrichtung mit einem als Wheatstonebrücke dargestellten Sensor oder einer Kraftmesszelle und mit einer Signalverarbeitungseinheit die mit einem Ausblendmittel versehen ist, welches einen Triggersignal-Schalter und eine mit dem Triggersignal-Schalter verbundene Ausblendsteuerung aufweist, wobei der Triggersignal-Schalter die zur A/D-Wandlung notwendigen Triggersignale eines Triggersignalgenerators unterbricht;
- Figur 6: die wichtigsten, in Figur 5 auftretenden Signalverläufe;
- Figur 7: eine schematisch dargestellte Messvorrichtung mit einem als Wheatstonebrücke dargestellten Sensor oder einer Kraftmesszelle und mit einer Signalverarbeitungseinheit die mit einem Ausblendmittel versehen ist, welches eine Kombination von Triggersignalgenerator und Ausblendsteuerung darstellt, wobei die Ausblendsteuerung die Freigabe beziehungsweise die Blockierung der Triggersignale bewirkt;
- Figur 8: die wichtigsten, in Figur 7 auftretenden Signalverläufe;
- Figur 9: eine schematisch dargestellte Messvorrichtung mit mehreren Sensoren oder Kraftmesszellen und mit einer Signalverarbeitungseinheit die mit einem Multiplexer und einem Ausblendmittel versehen ist, das eine Kombination von Triggersignalgenerator und Ausblendsteuerung darstellt, wobei die Ausblendsteuerung die Freigabe beziehungsweise die Blockierung der Triggersignale bewirkt;
- Figur 10: die wichtigsten, in Figur 9 auftretenden Signalverläufe;
- Figur 11: verschiedene Signalverläufe einer Verstärkerschaltung gemäss dem Stand der Technik, zur Visualisierung der Exemplarstreuung und des Temperatureinflusses.

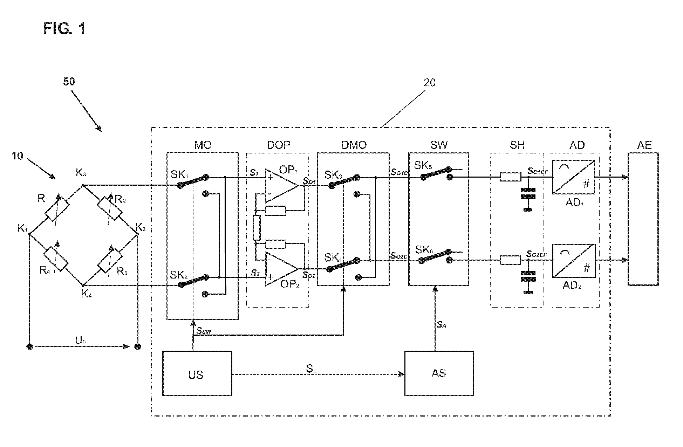

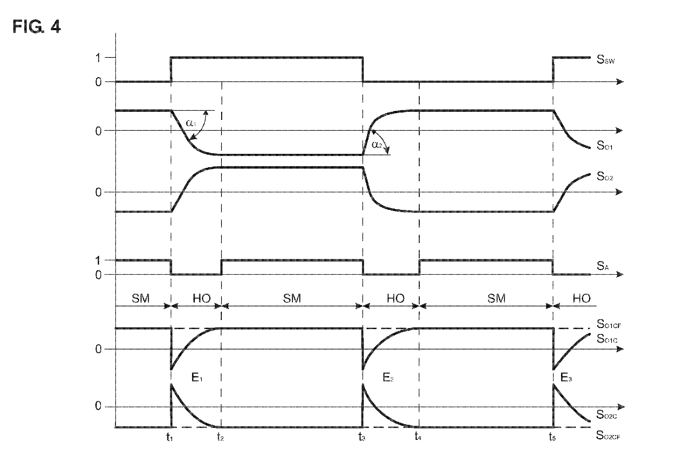

Figur 1 zeigt eine schematisch dargestellte Messvorrichtung 50 mit einem als Wheatstonebrücke dargestellten Sensor 10. Das eigentliche Sensorelement muss in seinem Widerstand variabel sein, so dass dessen Widerstand idealerweise der Veränderung des zu messenden Parameters linear oder zumindest nach einer bekannten Gesetzmässigkeit folgt. Bekanntermassen ist in einer Vollbrücke mindestens einer der vier schematisch dargestellten Widerstände R₁, R₂, R₃, R₄ oder in einer Halbbrücke mindestens einer der beiden Widerstände R₁, R₂ variabel. Beispielsweise werden die Dehnmessstreifen einer Kraftmesszelle in dieser Art verschaltet. Zwischen den Knotenpunkten K₁ und K₂ der Wheatstonebrücke ist eine Betriebsspannung U₀ angelegt. Die beiden Knotenpunkte K₃ und K₄ sind mit einer Signalverarbeitungseinheit 20 verbunden, welche verschiedene Verarbeitungsstufen MO, DOP, DMO, SW, SH, AD, AE beinhaltet, die in dieser Reihenfolge miteinander verschaltet sind. Die erste Verarbeitungsstufe der Signalverarbeitungseinheit ist ein Modulator MO, der mindestens zwei Schaltkontakte SK₁, SK₂ aufweist, wobei der Schaltkontakt SK₁ mit dem Knotenpunkt K₃ und der Schaltkontakt SK₂ mit dem Knotenpunkt K₄ verbunden ist. Je nach Schaltkontaktstellung der Schaltkontakte SK₁, SK₂ sind die Knotenpunkte K₃, K₄ stets voneinander getrennt, aber abwechslungsweise mit dem Verstärkersignal-Eingang eines ersten Verstärkers OP₁ oder mit dem Verstärkersignal-Eingang eines zweiten Verstärker OP₂ eines Differenzverstärkers DOP verbunden. Dem Differenzverstärker DOP nachgeschaltet ist ein Demodulator DMO, dessen Aufbau identisch mit dem Aufbau des Modulators MO ist. Somit weist der Demodulator DMO ebenfalls mindestens zwei Eingänge, mindestens zwei Ausgänge und mindestens zwei Schaltkontakte SK₃, SK₄ auf, wobei der Schaltkontakt SK₃ mit dem Verstärker-Ausgang des Verstärkers OP₁ und der Schaltkontakt SK₄ mit dem Verstärker-Ausgang des Verstärkers OP₂ verbunden ist. Die vier Schaltkontakte SK₁, SK₂, SK₃, SK₄ werden mittels einer Umschaltsteuerung US synchron betätigt. Dem Demodulator DMO ist ein Schalter SW nachgeschaltet, welcher mindestens gleich viele Schaltkontakte SK₅, SK₆ wie der Demodulator DMO aufweist. Die beiden Schaltkontakte SK₅, SK₆ sind je mit einem Ausgang des Demodulators DMO verbunden und verbinden diese Ausgänge entweder mit den nachfolgenden Verarbeitungsstufen SH, AD, AE oder schalten die Ausgänge hochohmig. Somit werden die Ausgänge des Demodulators DMO entweder mit den nachgeschalteten Verarbeitungsstufen SH, AD, AE verbunden oder getrennt. Betätigt werden die Schaltkontakte SK₅, SK₆ über eine Ausblendsteuerung AS. Vorzugsweise ist die Ausblendsteuerung AS über eine Signalleitung S_{L} mit der Umschaltsteuerung US verbunden, so dass das Umschaltsignal S_{SW} der Umschaltsteuerung US gleichzeitig der Triggerung des Ausblendsignals A_{S} dient. Mit der Triggerung werden die Schaltkontakte SK₅, SK₆ hochohmig geschaltet. Die Ausblendphasendauer kann fix definiert und eingespeichert sein. Die Ausblendsteuerung AS kann aber auch über Mittel, beispielsweise einen Prozessor und einen Speicher verfügen, mit deren Hilfe die Ausblendphasendauer während der Initialisierung berechnet werden kann und danach während der Betriebsphase fix eingestellt bleibt. Bei Ende der Ausblendphase werden die Schaltkontakte SK₅, SK₆ zurückgeschaltet, so dass die Ausgänge des Demodulators DMO wieder mit den nachgeschalteten Verarbeitungsstufen SH, AD, AE verbunden sind. Selbstverständlich kann die Ausblendphasendauer auch mittels Zeitglieder hardwaremässig definiert werden. Der Ausblendzyklus folgt somit dem Umschaltzyklus des Modulators MO und Demodulators DMO. Die nachgeschalteten Verarbeitungsstufen SH, AD, AE dienen lediglich der Weiterverarbeitung der Signale wobei eine Sample and Hold Verarbeitungsstufe SH, bestehend aus je einem, jedem Signalpfad zugeordneten R/C-Tiefpassglied der Überbrückung der Ausblendphase dient. Üblicherweise werden die analogen Signale vermittels einer Analog-Digital-Wandlerschaltung AD in digitale Signale umgewandelt und einem Prozessor zur Weiterverarbeitung oder einer Anzeigeeinheit AE zugeführt. Je Signalpfad ist im vorliegenden Beispiel jeweils ein A/D-Wandler AD₁, AD₂ zugeordnet. Alle in Figur 1 eingezeichneten Signale sind nachfolgend in der Beschreibung von Figur 4 ausführlich erklärt.

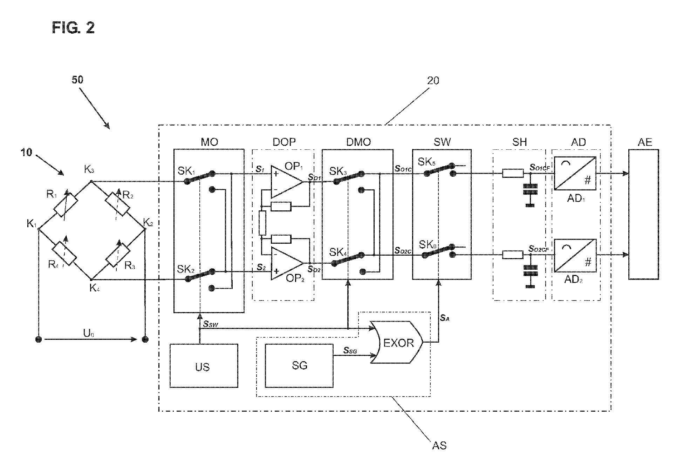

In Figur 2 ist eine Messvorrichtung 50 mit einem Sensor 10 und mit einer Signalverarbeitungseinheit 20 schematisch dargestellt. Alle Elemente entsprechen denjenigen der Figur 1, wobei die Ausblendsteuerung AS näher spezifiziert ist. Die Ausblendsteuerung AS besteht aus einem Signalgenerator SG und einem EXOR-Element EXOR. Die Signalgeneratorsignale S_{SG} und die Umschaltsignale S_{SW} werden den Signaleingängen des EXOR-Elements EXOR zugeführt. Sobald die Eingangswerte S_{SG}, S_{SW} ungleich sind, wirkte ein Ausblendsignal S_{A} auf die Schaltkontakte SK₅, SK₆ ein. Somit werden die Ausblendphasen t₁ bis t₂, t₃ bis t₄, t₅ bis t_{...}, und deren Phasendauer über den Phasenversatz des Signalgeneratorsignals S_{SG} gegenüber dem Umschaltsignal S_{SW} erzeugt. Alle in Figur 2 eingezeichneten Signale sind nachfolgend in der Beschreibung von Figur 4 ausführlich erklärt.

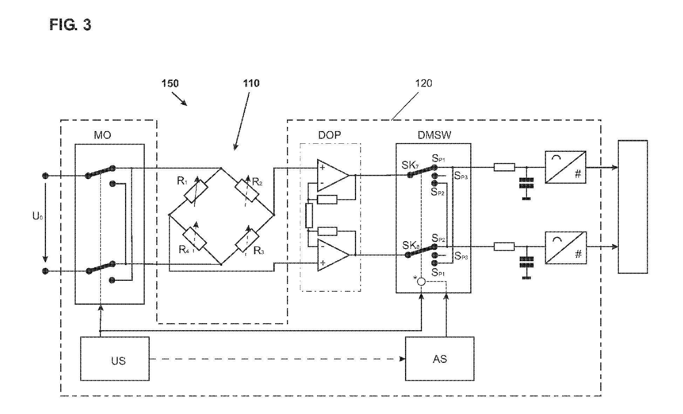

In Figur 3 ist eine Messvorrichtung 150 mit einem Sensor 110 und mit einer Signalverarbeitungseinheit 120 schematisch dargestellt. Bis auf den hier fehlenden Demodulator DMO und den Schalter SW aus Figur 1, entsprechen alle übrigen Elemente denjenigen der der Figur 1. In Bezug auf die Verschaltung der einzelnen Verarbeitungsstufen wurde gegenüber der Figur 1 lediglich der Sensor 150 zwischen dem Modulator MO und dem Differenzverstärker DOP angeordnet, um die oben erwähnten Vorteile einer mit Wechselspannung betriebenen Messbrücke zu erhalten. Der einzige wesentliche Unterschied der in der Figur 3 dargestellten Schaltung gegenüber jener der Figur 1 liegt darin, dass die anhand Figur 1 beschriebenen Verarbeitungsstufen Demodulator DMO und Schalter SW miteinander kombiniert wurden. Im Demodulationsschalter DMSW ist eine hochohmige Schaltstufe S_{P3} integriert, die zwischen den beiden, jeweils mit einem Signal-Ausgang des Demodulationsschalters DMSW verbundenen Schaltpositionen S_{P1}, S_{P2} eines Schaltkontaktes SK₇, SK₈ angeordnet ist. Anstelle der Schaltstufe S_{P3} kann sinngemäss der jeweilige Schaltkontakt SK₇, SK₈ zwischen den Schaltpositionen S_{P1}, S_{P2} in einem hochohmigen Zustand gehalten werden. Sowohl die Umschaltsteuerung US als auch die Ausblendsteuerung AS wirken auf die Schaltkontakte SK₇, SK₈ ein, so dass beispielsweise durch eine Überlagerung der Steuersignale dieser Steuerelemente AS, US, eine Ausblendphase erzeugt wird.

In Figur 4 sind die wichtigsten, in Figur 1, Figur 2 und Figur 3 auftretenden Signalverläufe dargestellt. Im ersten Kurvenzug ist ein möglicher Verlauf der Umschaltsteuersignale S_{SW} gezeigt. Der zweite Kurvenzug beschreibt ein erstes Ausgangssignal S_{O1} am Ausgang des ersten Verstärkers OP₁. Wie in Figur 11 ebenfalls dargestellt und in deren Figurenbeschreibung untenstehend ausführlich erklärt, ist deutlich erkennbar, dass die Anstiegszeit und Bandbreite begrenzt sind und sich dies auf das Ausgangssignal auswirkt. Ebenfalls ist klar ersichtlich, dass sich die Anstiegsrate α₁, α₂ von Periode zu Periode verändern kann.

Der dritte Kurvenzug zeigt ein zweites Ausgangssignal S_{O2} des zweiten Verstärkers OP₂. Auch hier ist der Einfluss der begrenzten Anstiegszeit und Bandbreite deutlich sichtbar. Der vierte Kurvenzug zeigt ein mögliches Ausblendesignal S_{A}, welches hier low active gezeichnet ist. Der fünfte Kurvenzug stellt das erste demodulierte Ausgangssignal S_{O1C} dar, so wie das erste Ausgangssignal S_{O1C} hinter dem Demodulator DMO aussieht, wenn die Schaltkontakte SK₅, SK₆ ebenfalls mit dem im ersten Kurvenzug gezeigten Umschaltsteuersignal S_{SW} angesteuert werden. Die Einbrüche E₁, E₂, E₃ im ersten demodulierten Ausgangssignal S_{O1C} in den Ausblendphasen t₁ bis t₂, t₃ bis t₄, t₅ bis t_{3...}, sind deutlich sichtbar. Die unterbrochen gezeichnete Linie zeigt das demodulierte und vermittels dem RC-Tiefpassfilter der Sample and Hold Verarbeitungsstufe SH gefilterte Ausgangssignal S_{O1CF} am Eingang des ersten A/D-Wandlers AD₁. Die einzelnen Samplephasen SM und Holdphasen HO sind ebenfalls in der Grafik eingezeichnet und zeigen deutlich, wie sich die Phasen von Sampling und Hold entsprechend dem Ausblendesignal S_{A} abwechseln. Der sechste Kurvenzug zeigt sinngemäss das entsprechende zweite demodulierte Ausgangssignal S_{O2C} hinter dem Demodulator und das zugehörige zweite demodulierte und gefilterte Ausgangssignal S_{O2CF} am Eingang des zweiten A/D-Wandlers AD₂.

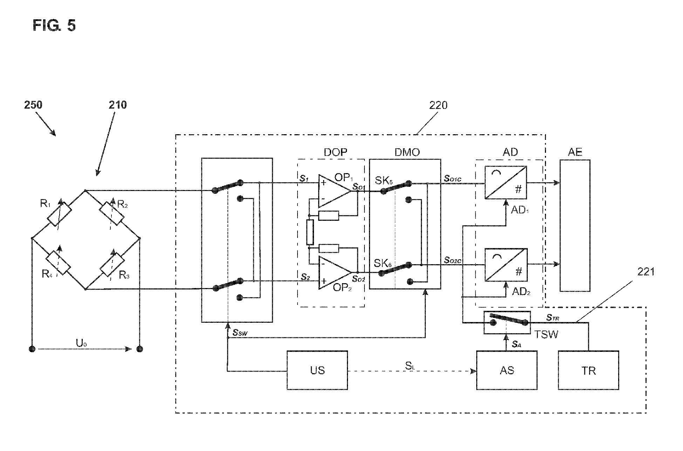

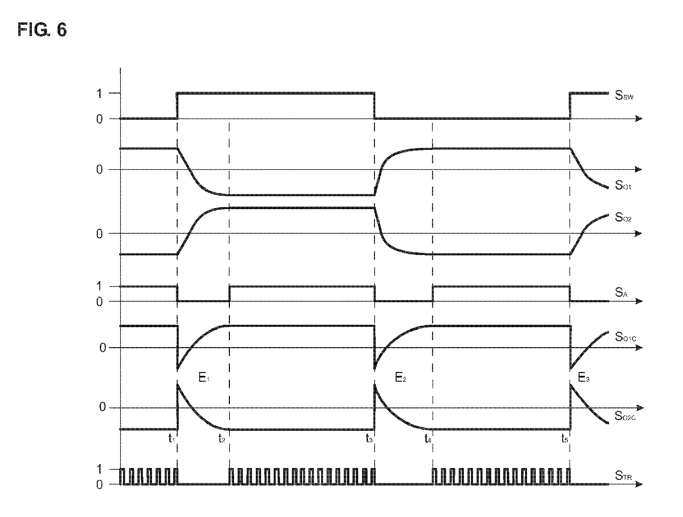

Die in Figur 5 schematisch dargestellte Messvorrichtung 250 mit ihrem Sensor 210 und ihrer Signalverarbeitung 220 entspricht in den Verarbeitungsstufen und in deren Verschaltung vom Sensor 210 bis zu den Signalausgängen des Demodulators DMO ebenfalls dem in Figur 1 dargestellten Ausführungsbeispiel. Auch hier wird ein Differenzverstärker DOP mit zwei Verstärkern OP₁, OP₂ verwendet. Anstelle der beiden Verarbeitungsstufen Schalter SW und Sample and Hold SH werden die Signalausgänge des Demodulators DMO jeweils direkt mit den ihnen zugeordneten Signaleingängen der A/D-Wandler AD₁, AD₂ verbunden. Die Sample and Hold Verarbeitungsstufe SH kann bei der Verwendung bestimmter A/D-Wandler entfallen. Die Ausblendphase wird dadurch erzeugt, dass die Ausblendsteuerung AS auf einen Triggersignalschalter TSW einwirkt, der die Triggersignalleitung 221 zwischen einem Triggersignalgenerator TR und den A/D- Wandlern AD₁, AD₂ für die Dauer der Ausblendphasen unterbricht. Bekanntlich wandeln A/D- Wandler nur dann Analogsignale in Digitalsignale um, wenn dem A/D-Wandler Triggersignale zugeführt werden. Durch die Unterbrechung der Triggersignalleitung 221 wird die A/D-Wandlung somit blockiert. Die nachfolgende Verarbeitungsstufe ist wie in Figur 1 wiederum eine nachgeschaltete Verarbeitungsstufe, beispielsweise ein Prozessor zur Weiterverarbeitung der Signale oder eine Anzeigeeinheit AE. Alle in Figur 5 eingezeichneten Signale sind nachfolgend in der Beschreibung von Figur 6 ausführlich erklärt.

In Figur 6 sind die wichtigsten, in Figur 5 auftretenden Signalverläufe dargestellt. Im ersten Kurvenzug ist ein möglicher Verlauf der Umschaltsteuersignale S_{SW} gezeigt. Der zweite Kurvenzug beschreibt ein erstes Ausgangssignal S_{O1} am Ausgang des ersten Verstärkers OP₁. Der dritte Kurvenzug zeigt sinngemäss ein zweites Ausgangssignal S_{O2} des zweiten Verstärkers OP₂. Der vierte Kurvenzug zeigt ein mögliches Ausblendesignal S_{A}, welches hier low active gezeichnet ist. Der fünfte Kurvenzug stellt das erste demodulierte Ausgangssignal S_{O1C} dar, so wie das erste Ausgangssignal S_{O1C} hinter dem Demodulator DMO aussieht, wenn die Schaltkontakte SK₅, SK₆ ebenfalls mit dem im ersten Kurvenzug gezeigten Umschaltsteuersignal S_{SW} angesteuert werden. Die Einbrüche E₁, E₂, E₃ im ersten demodulierten Ausgangssignal S_{O1C} in den Ausblendphasen t₁ bis t₂, t₃ bis t₄, t₅ bis t_{...}, sind deutlich sichtbar. Der siebte Kurvenzug zeigt mögliche Triggersignale S_{TR} für die A/D-Wandler AD₁, AD₂. Es ist deutlich erkennbar, dass das Ausblendesignal S_{A}, welches auf den Triggersignalschalter TSW einwirkt, während den Ausblendphasen t₁ bis t₂, t₃ bis t₄, t₅ bis t_{...}, die Triggerung der A/D-Wandler unterdrückt.

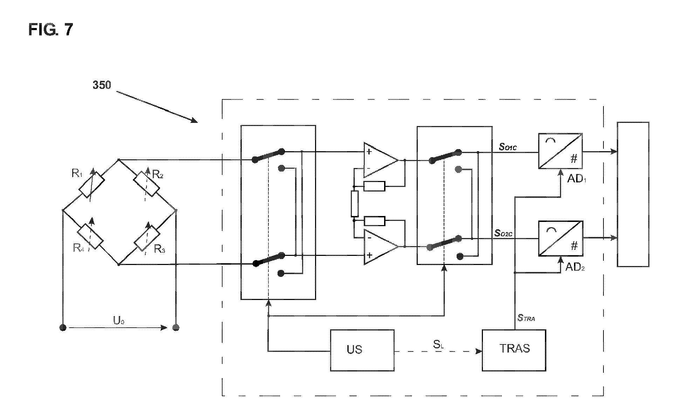

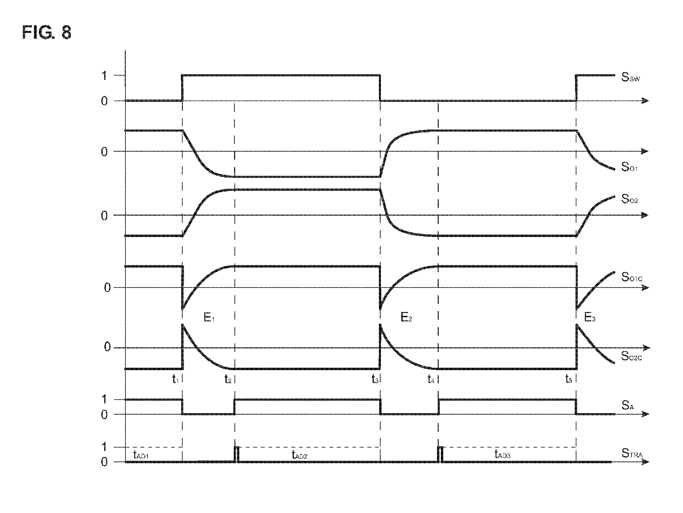

Die in Figur 7 dargestellte Messvorrichtung 350 weist im Wesentlichen dieselben Komponenten auf, wie das Ausführungsbeispiel in Figur 5. Deren Verschaltung entspricht ebenfalls der in Figur 5 gezeigten und ist vorangehend beschrieben. Wie die Figur 7 zeigt, können die Ausblend- und Triggersignale S_{TRA} auch in einer kombinierten Triggersignalgenerator/Ausblendsteuerung TRAS erzeugt werden. Damit entfällt der Triggersignalschalter TSW aus Figur 5. Die Umsetzung einer solchen kombinierten Steuerung kann mittels Hardware- und/oder Softwarelösungen realisiert werden. Beispielsweise kann das Ausblendesignal S_{A} direkt auf die Erzeugung der Triggersignale S_{TR} einwirken und sie entsprechend unterdrücken. Mit diesem kombinierten Triggersignal S_{TRA} wird die A/D- Wandlung der A/D-Wandler AD₁, AD₂, während den Ausblendphasen t₂ bis t₃, t₄ bis t₅, _{...} freigeschalten und während der Ausblendphasen t₁ bis t₂, t₃ bis t₄, t₅ bis t_{...}, blockiert. Wie in Figur 8 dargestellt, wird pro Modulatorphase nur ein einziges kombiniertes Triggersignal S_{TRA} für die A/D-Wandler erzeugt. Der Start der Wandlung wird jedoch durch die Ausblendsteuerung so gesteuert, dass die Signale an den Eingängen der A/D-Wandler keine Fehler mehr aufweisen. Eine noch weitergehende Integration der Steuerungskomponenten ist ebenfalls möglich, wenn die Umschaltsteuerung US in die kombinierte Steuerung TRAS integriert wird.

Die in Figur 8, dargestellten Signalverläufe Ssw, S_{O1}, S_{O2}, S_{O1C}, S_{O2C} und S_{A} entsprechen exakt den mit denselben Bezeichnungen versehenen Signalverläufen aus Figur 6. Der siebte Kurvenzug zeigt ein mögliches kombiniertes Triggersignal S_{TRA} für die A/D-Wandler. Es ist deutlich erkennbar, wie das Ausblendesignal S_{A} nach Ablauf der Ausblendphasen t₁ bis t₂, t₃ bis t₄, t₅ bis t..., mit fehlerhaften Verstärker-Ausgangssignalanteilen den Start der A/D-Wandler auslöst. Die Wandlungszeiten t_{AD1}, t_{AD2}, t_{AD3},... sind durch einen unterbrochenen Linienzug dargestellt. Während dieser Zeit dürfen die zu wandelnden Signale S_{O1C}, S_{O2C} nicht durch die Einschwingvorgänge der Verstärker verfälscht werden.

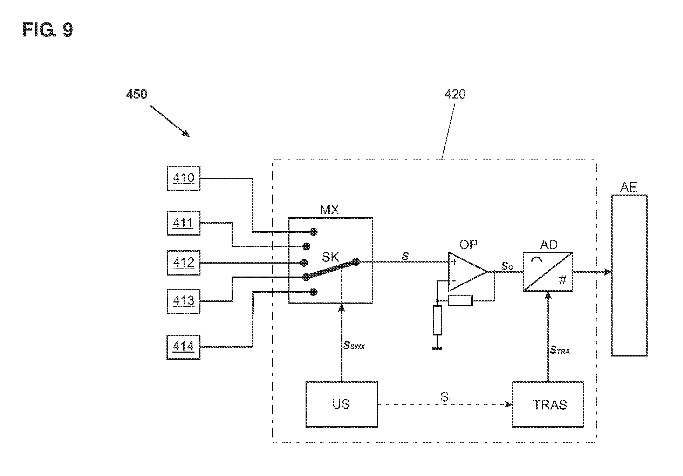

Figur 9 zeigt eine schematisch dargestellte Messvorrichtung 450 mit mehreren Sensoren oder Kraftmesszellen 410, 411, 412, 413, 414 und mit einer Signalverarbeitungseinheit 420, die mit einem Multiplexer MX versehen ist. In dieser weiteren, allgemein für Messvorrichtungen 450 und deren Signalverarbeitungseinheiten 420 verwendbaren Art, werden Übertragungsfehler eines analogen Verstärkers OP, verursacht durch dessen physikalisch begrenzte Wirkungsweise beim Nachfolgen eines Schaltsprunges im Verstärker-Eingangssignal S ebenfalls durch das erfindungsgemässe Verfahren verhindert. Solche Übertragungsfehler im Verstärker-Ausgangssignal S_{O} können beispielsweise entstehen, wenn die Sensorsignale mehrerer Sensoren 410, 411, 412, 413, 414 über den Multiplexer MX sequentiell dem Verstärker OP zugeführt werden. In diesem Fall muss der Ausgang des Verstärkers bei jedem Schaltvorgang durch den Schaltkontakt SK auf einen neuen Wert einschwingen. Analog dem vorangehend beschriebenen Verfahren können die nachfolgenden Verarbeitungsstufen AD, AE vom jeweils fehlerhaften Signalabschnitt E₁, E₂, E₃ getrennt werden, wie dies in Figur 1, Figur 2 und Figur 3 dargestellt ist. Selbstverständlich kann auch die Weiterverarbeitung wie in der Figur 5 oder Figur 7 unterdrückt werden, indem die nachfolgende Verarbeitungsstufe, hier ein Analog-Digital-Wandler AD, mittels einer kombinierten Triggersignal-Ausblendschaltung TRAS währen der Ausblendphasen t₁ bis t₂, t₃ bis t₄, t₅ bis t..., blockiert wird. Über eine Verbindungsleitung S_{L} wird die kombinierte Triggersignal-Ausblendschaltung T_{RAS} mit der Umschaltsteuerung US des Multiplexers MX koordiniert, wodurch die Ausblendphase des kombinierten Triggersignals S_{TRA} mit dem Umschaltsignal S_{WX} synchronisiert wird.

Figur 10 zeigt die wichtigsten, in Figur 9 auftretenden Signalverläufe S_{WX}, S_{O}, S_{A}, und S_{TRA}. Im ersten Kurvenzug ist ein möglicher Verlauf des Multiplexer-Umschaltsteuersignal S_{SWX} gezeigt, die Werte sind in im Hexadezimalcode angegeben.

Der zweite Kurvenzug beschreibt ein mögliches Verstärker-Ausgangsignal S_{O}. Man sieht auch hier deutlich wie die Anstiegszeit und Bandbreite des Verstärkers OP begrenzt ist und sich dies auf das Verstärker-Ausgangssignal S_{O} auswirkt. Da das Verstärker-Ausgangssignal S_{O} aus den Ausgangssignalen verschiedener Messzellen zusammengesetzt ist, variiert auch die Amplitude der einzelnen Signalperioden. Der dritte Kurvenzug zeigt ein mögliches Ausblendesignal S_{A}, welches nicht von der kombinierten Triggersignal-Ausblendsteuerung nach Aussen gegeben wird sondern der internen Verarbeitung dient, um das kombinierte Triggersignal S_{TRA} zu erzeugen.

Der vierte Kurvenzug zeigt dieses kombinierte Triggersignal S_{TRA} für den A/D-Wandler. Es ist deutlich erkennbar, wie das Ausblendesignal A_{S} nach Ablauf der fehlerhaften Signalabschnitte E₁, E₂, E₃ des fehlerbehafteten Verstärker-Ausgangssignals S_{O} den Start des A/D-Wandlers triggert. Die Wandlungszeiten t_{AD1}, t_{AD2}, t_{AD3},... sind durch einen unterbrochenen Linienzug dargestellt. Während dieser Zeit dürfen die zu wandelnden Signale nicht durch die Einschwingvorgänge des Verstärkers verfälscht werden.

Figur 11 zeigt verschiedene Signalverläufe einer Verstärkerschaltung gemäss dem Stand der Technik, um die Exemplarstreuung und den Temperatureinfluss von baugleichen Verstärkern zu veranschaulichen. Ausgehend von einem Sprung im Verstärker-Eingangssignal S_{OPin} zum Zeitpunkt t₁ und einem weiteren Sprung zum Zeitpunkt t₂, folgt das theoretische Verstärker-Ausgangsignal S_{OPoutT} ebenfalls sprunghaft und unverzögert dem Verstärker-Eingangssignal S_{OPin}. In der Praxis verhält sich ein Verstärker aufgrund seiner physikalisch begrenzten Wirkungsweise überhaupt nicht so. Der Verstärker weist eine bestimmte Anstiegszeit τ auf, welche aus der Anstiegsrate α berechnet werden kann. Diesem theoretisch linear verlaufenden Anstiegsverhalten überlagert ist aber noch das Einschwingverhalten des Verstärkers, das massgeblich durch den Feedback-Widerstand und den Feedback-Kondensator beeinflusst wird und annäherungsweise einer Exponentialfunktion entspricht. So entsteht ein Verstärker-Ausgangssignal, welches beispielsweise bei einer Verstärker-Betriebstemperatur von 20°C der Ausgangssignalkurve S_{OPout1} entspricht. Wird dieses Signal anschliessend vermittels eines Tiefpassfilters geglättet, entspricht das Signal in etwa der Signalkurve S_{OPoutF.} Wird ein identisch aufgebauter zweiter Verstärker bei gleicher Temperatur ausgemessen, so kann dieser ein vom ersten Verstärker abweichendes Ausgangssignal aufweisen, beispielsweise die in der Figur 11 dargestellte Ausgangssignalkurve S_{OPout2}. Versuche mit demselben Bauteil haben auch ergeben, dass sich das Einschwingverhalten bei unterschiedlichen Betriebstemperaturen massiv verändert. So kann das Ausgangssignal des ersten Verstärkers bei einer Betriebstemperatur von 60°C beispielsweise der Ausgangssignalkurve S_{OPout3} entsprechen. Es liegt auf der Hand, dass die gefilterten Verstärker-Ausgangssignale dieser drei Kurvenzüge auch unterschiedliche Amplituden aufweisen.

Selbstverständlich ist das erfindungsgemässe Verfahren nicht nur auf eine Messvorrichtung mit einer Dehnmessstreifen-Kraftmessvorrichtung anwendbar, sondern auch in Messvorrichtungen, die nach dem Prinzip der elektromagnetischen Kraftkompensation arbeiten. Zudem kann jedes Ausgangssignal von Sensoren wie Feuchtesensoren, Temperatursensoren, Feldeffekttransistor-Sensoren und dergleichen mit analogen Verstärkern verstärkt, und das Verstärker-Ausgangssignal mittels dem erfindungsgemässen Verfahren von Übertragungsfehlern des analogen Verstärkers, verursacht durch dessen physikalisch begrenzte Wirkungsweise beim Nachfolgen eines Schaltsprunges im Verstärker-Eingangssignal, befreit werden.

## Patentansprüche

1. Verfahren zur Korrektur von Übertragungsfehlern eines analogen Verstärkers (OP, DOP), verursacht durch dessen physikalisch begrenzte Wirkungsweise beim Nachfolgen eines Schaltsprunges im Verstärker-Eingangssignal (S₁, S₂), wobei eine Signalverarbeitungseinheit (20) mindestens einen Modulator (MO) und/oder einen Multiplexer (MX), einen analogen Verstärker (OP, DOP) und mindestens eine dem analogen Verstärker (OP, DOP) nachgeschaltete Verarbeitungsstufe (AD, AE) aufweist, **dadurch gekennzeichnet, dass**
a. abhängig vom Schaltzeitpunkt des Schaltsprunges die nachgeschaltete Verarbeitungsstufe (AD, AE) während einer vorbestimmten Ausblendphasendauer (t₁ bis t₂, t₃ bis...) vom analogen Verstärker (OP, DOP) getrennt wird und/oder dass
b. abhängig vom Schaltzeitpunkt des Schaltsprunges die nachgeschaltete Verarbeitungsstufe (AD, AE) während einer vorbestimmten Ausblendphasendauer (t₁ bis t₂, t₃ bis...) blockiert wird.

2. Verfahren nach Anspruch 1, **dadurch gekennzeichnet, dass** die vorbestimmte Ausblendphasendauer (t₁ bis t₂, t₃ bis...) der Anstiegszeit (τ) oder der Zeitkonstanten des analogen Verstärkers (OP, DOP), multipliziert mit einem Faktor welcher zwischen 2 und 10 liegt, entspricht.

3. Verfahren nach Anspruch 1 oder 2, **dadurch gekennzeichnet, dass** die nachgeschaltete Verarbeitungsstufe (AD, AE) vom analogen Verstärker (OP, DOP) mittels eines Schalters (SW) getrennt wird, wobei der Schalter (SW) zwischen dem analogen Verstärker (OP, DOP) und der nachgeschalteten Verarbeitungsstufe (AD, AE) angeordnet ist und durch eine Ausblendsteuerung (AS) angesteuert wird.

4. Verfahren nach Anspruch 1 oder 2, **dadurch gekennzeichnet, dass** die Signalverarbeitungseinheit (120) einen dem analogen Verstärker (OP, DOP) nachgeschalteten Demodulationsschalter (DMSW) aufweist, wobei eine Umschaltsteuerung (US) des Modulators (MO) zur synchronen Demodulation des modulierten Signals auf den Demodulationsschalter (DMSW) einwirkt und eine Ausblendsteuerung (AS) während der Ausblendphasendauer (t₁ bis t₂, t₃ bis...) vermittels eines Ausblendsignals (S_{A}) den Demodulationsschalter (DMSW) in einer hochohmigen Schaltstufe (S_{P3}) oder in einem hochohmigen Zustand hält.

5. Verfahren nach einem der Ansprüche 1 bis 4, **dadurch gekennzeichnet, dass** die nachgeschaltete Verarbeitungsstufe eine Analog-Digital-Wandlerschaltung (AD) ist, wobei zur Erzeugung einer Ausblendphase eine Ausblendsteuerung (AS) auf einen Triggersignal-Schalter (TSW) einwirkt und der Triggersignal-Schalter (TSW) ein zur A/D-Wandlung notwendiges Triggersignal (S_{TR}) während der Ausblendphasendauer (t₁ bis t₂, t₃ bis...) unterbricht.

6. Verfahren nach einem der Ansprüche 1 bis 4, **dadurch gekennzeichnet, dass** die nachgeschaltete Verarbeitungsstufe eine Analog-Digital-Wandlerschaltung (AD) ist und dass zur Erzeugung einer Ausblendphase die Ausblendsteuerung (AS) mit einem Triggersignalgenerator (TR), welcher die zur A/D-Wandlung notwendigen Triggersignale erzeugt, eine kombinierte Triggersignalgenerator/Ausblendsteuerung (TRAS) bildet, wobei die von der Ausblendsteuerung (AS) erzeugten Ausblendsignale (S_{A}) den Triggersignalen (S_{TR}) während der Ausblendphasendauer (t₁ bis t₂, t₃ bis...) überlagert werden oder die Generierung der Triggersignale (S_{TR}) unterdrückt wird.

7. Verfahren nach einem der Ansprüche 1 bis 6, **dadurch gekennzeichnet, dass** der Modulator (MO) und/oder der Multiplexer (MX) mit einer Umschaltsteuerung (US) versehen ist, und dass die Ausblendsignale (S_{A}) der Ausblendsteuerung (AS) in Abhängigkeit der Umschaltsignale (S_{SW}) der Umschaltsteuerung (US) generiert werden.

8. Verfahren nach einem der Ansprüche 1 bis 7, **dadurch gekennzeichnet, dass** das Ausgangssignal mindestens eines Sensors (10, 110,...) dem Verstärker (OP, DOP) als Verstärker-Eingangssignal (S₁, S₂) zugeführt wird.

9. Verfahren nach Anspruch 8, **dadurch gekennzeichnet, dass** vermittels des Modulators (MO) das Verstärker-Eingangssignal (S₁, S₂) oder die Eingangsspannung des Sensors vorzugsweise als Rechteckwechselspannungssignal moduliert wird.

10. Verfahren nach Anspruch 8 oder 9, **dadurch gekennzeichnet, dass** die Ausgangssignale mindestens zweier Sensoren (410, 411,...) sequentiell vermittels des Multiplexers (MX) dem mindestens einen analogen Verstärker (OP) zugeführt werden.

11. Verstärkermodul oder integriertes Verstärkermodul, geeignet zur Durchführung des Verfahrens nach einem der Ansprüche 1 bis 10, **dadurch gekennzeichnet, dass** das Verstärkermodul mindestens einen Modulator (MO) und/oder einen Multiplexer (MX) mit mindestens einer Umschaltsteuerung (US), dem Modulator (MO) und/oder dem Multiplexer (MX) nachgeschaltet mindestens einen analogen Verstärker (OP), und diesem Verstärker (OP) nachgeschaltet mindestens eine Verarbeitungsstufe aufweist, wobei die nachgeschaltete Verarbeitungsstufe mindestens ein Ausblendmittel beinhaltet, das der Erzeugung einer Ausblendphase mit einer vorbestimmten Ausblendphasendauer (t₁ bis t₂, t₃ bis...) im Verstärker-Ausgangssignal dient.

12. Messvorrichtung (50, 150,...), geeignet zur Durchführung des Verfahrens nach einem der Ansprüche 1 bis 10, mit mindestens einer Signalverarbeitungseinheit (20) und mit mindestens einem Sensor (10), wobei die Signalverarbeitungseinheit (20) einen Modulator (MO) und/oder einen Multiplexer (MX) mit einer Umschaltsteuerung (US) aufweist, dem Modulator (MO) und/oder dem Multiplexer (MX) mindestens ein analoger Verstärker (OP₁, OP₂), und diesem Verstärker (OP₁, OP₂) mindestens eine Verarbeitungsstufe (AD, AE) nachgeschaltet ist, **dadurch gekennzeichnet, dass** die mindestens eine Signalverarbeitungseinheit (20) mindestens ein Ausblendmittel aufweist, das der Erzeugung einer Ausblendphase mit einer vorbestimmten Ausblendphasendauer (t₁ bis t₂, t₃ bis...) im Verstärker-Ausgangssignal (S_{O1CF}, S_{O2CF}) dient.

13. Messvorrichtung (50) nach Anspruch 12, **dadurch gekennzeichnet, dass** der Modulator (MO) unmittelbar vor dem analogen Verstärker (DOP) angeordnet ist und dass der Modulator (MO) der Modulation des Verstärker-Eingangssignals (S₁, S₂) dient.

14. Messvorrichtung (150) nach Anspruch 12, **dadurch gekennzeichnet, dass** der Modulator (MO) vor dem mindestens einen Sensor (110) angeordnet ist, und dass der Modulator (MO) der Modulation der Versorgungsspannung (U₀) des Sensors (10) und/oder der Kraftmesszelle (10) und dadurch der Modulation des Verstärker-Eingangssignals (S₁, S₂) dient.

15. Messvorrichtung (50) nach einem der Ansprüche 12 bis 14, **dadurch gekennzeichnet, dass** das Ausblendmittel ein der Signalverarbeitungseinheit (20) zugeordneter Schalter (SW) und eine mit dem Schalter (SW) verbundene Ausblendsteuerung (AS) ist, und dass die Umschaltsignale (S_{A}) der Umschaltsteuerung (US) zur Ansteuerung der Ausblendsteuerung (AS) geeignet sind.

16. Messvorrichtung (50) nach Anspruch 15, **dadurch gekennzeichnet, dass** die Ausblendsteuerung (AS) einen Signalgenerator (SG) und ein EXOR-Element (EXOR) aufweist und dass das EXOR-Element (EXOR) durch Kombinieren der Signalgeneratorsignale (S_{SG}) mit den Umschaltsignalen (S_{SW}) der Erzeugung der Ausblendsignale (S_{A}) dient.

17. Messvorrichtung (150) nach einem der Ansprüche 12 bis 14, **dadurch gekennzeichnet, dass** die Messvorrichtung (150) einen dem analogen Verstärker (DOP) nachgeschalteter Demodulationsschalter (DMSW) aufweist und dass der Demodulationsschalter (DMSW) mit der Umschaltsteuerung (US) des Modulators (MO) verbunden ist, dass das Ausblendmittel eine mit dem Demodulationsschalter (DMSW) verbundene Ausblendsteuerung (AS) und eine im Demodulationsschalter (DMSW) integrierte hochohmige Schaltstufe (S_{P3}) oder ein Demodulationsschalter (DMSW) mit in hochohmigem Zustand haltbaren Schaltkontakten (SK₇, SK₈) ist, wobei die Umschaltsignale (S_{SW}) der Umschaltsteuerung (US) zur Ansteuerung der Ausblendsteuerung (AS) der hochohmigen Schaltstufe (S_{P3}) geeignet sind und die von der Ausblendsteuerung (AS) erzeugten Ausblendsignale (S_{A}) den Umschaltsignalen (S_{SW}) überlagerbar, oder die Ausblendsignale (S_{A}) mit den Umschaltsignalen (S_{SW}) kombinierbar sind.

18. Messvorrichtung (250) nach einem der Ansprüche 12 bis 14, **dadurch gekennzeichnet, dass** die nachgeschaltete Verarbeitungsstufe eine Analog-Digital-Wandlerschaltung (AD) ist, dass das Ausblendmittel ein Triggersignal-Schalter (TSW) und eine mit dem Triggersignal-Schalter (TSW) verbundene Ausblendsteuerung (AS) ist, wobei der Triggersignal-Schalter (TSW) ein zur A/D-Wandlung notwendiges Triggersignal (S_{TR}) unterbricht, und dass die Umschaltsignale (S_{SW}) der Umschaltsteuerung (US) zur Ansteuerung der Ausblendsteuerung (AS) geeignet sind.

19. Messvorrichtung (350) nach einem der Ansprüche 12 bis 14, **dadurch gekennzeichnet, dass** die nachgeschaltete Verarbeitungsstufe eine Analog-Digital-Wandlerschaltung (AD) ist, und dass das Ausblendmittel eine kombinierte Triggersignalgenerator/Ausblendsteuerung (TRAS) ist, welche der Erzeugung der zur A/D-Wandlung notwendigen Triggersignale (S_{TRA}) dient, wobei die Umschaltsignale (S_{SW}) der Umschaltsteuerung (US) zur Ansteuerung der Ausblendsteuerung (AS) geeignet sind und die Ausblendsteuerung (AS) der Freigabe beziehungsweise der Blockierung der Triggersignale (S_{TRA}) dient.

20. Messvorrichtung (350) nach einem der Ansprüche 12 bis 19, **dadurch gekennzeichnet, dass** der mindestens eine Sensor ein Feuchtesensor, ein Temperatursensor, ein Drucksensor eine Kraftmesszelle mit Dehnungsmessstreifen oder eine Kraftmesszelle nach dem Prinzip der elektromagnetischen Kraftkompensation ist.
